# EUROPÄISCHE PATENTSCHRIFT

(11) **EP 1 466 181 B1**
(45) Veröffentlichungstag und Bekanntmachung des Hinweises auf die Patenterteilung: **12.12.2007**
(21) Anmeldenummer: 02801068.4
(22) Anmeldetag: 23.12.2002
(51) Int. Cl.: G01R 1/073, G01N 27/90

(54) **SONDE FüR ELEKTRISCHE MESSVERFAHREN UND VERWENDUNG EINER FLEXIBLEN SONDE ZUR HERSTELLUNG EINER UNFLEXIBLEN SONDE**
PROBE FOR ELECTRICAL MEASUREMENT METHODS AND USE OF A FLEXIBLE PROBE FOR PRODUCTION OF A RIGID PROBE
SONDE POUR PROCEDES DE MESURE ELECTRIQUE ET UTILISATION D'UNE SONDE FLEXIBLE POUR PRODUIRE UNE SONDE NON FLEXIBLE

(30) Priorität: 17.01.2002 EP 02001268
(43) Veröffentlichungstag der Anmeldung: 13.10.2004
(73) Patentinhaber: SIEMENS AKTIENGESELLSCHAFT, 80506 München (DE)
(72) Erfinder: BÄR, Ludwig, 91056 Erlangen (DE); HEINRICH, Werner, 16727 Bärenklau (DE)
(86) Internationale Anmeldenummer: PCT/EP2002/014738
(87) Internationale Veröffentlichungsnummer: WO 2003/060530

(56) Entgegenhaltungen:
- EP-A- 0 228 177
- EP-A- 0 556 557
- WO-A-01/63308
- US-A- 5 467 775

## Beschreibung

Die Erfindung geht aus von einer Sonde für elektrische Messverfahren gemäß dem Gattungsbegriff des Anspruchs 1 und einer Verwendung einer flexiblen Sonde zur Herstellung einer unflexiblen Sonde nach Anspruch 8.

Aus der DE 197 48 556 A1 ist eine Sonde für eine Wirbelstrommessung mit einer ferromagnetischen Signalverstärkung bekannt, wobei die Signalverstärkung durch einen starren ferritischen Kern erzeugt wird. Mit einer aus einem starren Substrat, auf dem planare Spulen aufgebracht sind, gebildeten Sonde können nur Prüfkörper mit ebener Oberfläche vermessen werden. Bei unebenen Oberflächen muss die Sonde in ihrer Form einer Oberfläche des Prüfkörpers angepasst sein, anderenfalls ergeben sich falsche Messwerte.

Eine Sonde mit Wirbelstrommessung mit ferromagnetischer Signalverstärkung für ebene Prüfkörper ist auch aus der US-PS 6,002,251 bekannt.

Aus der US-PS 5,389,876 ist eine Sonde für eine Wirbelstrommessung bekannt, die jedoch nur schwache Signale liefert.

Aus der EP 0 228 177 ist eine flexible Sonde für elektrische Messverfahren bekannt.

Aufgabe der Erfindung ist es daher, eine verbesserte Sonde für elektrische Messverfahren aufzuzeigen, die auch für verschieden gekrümmte Oberflächen eines Prüfkörpers verwendet werden kann.

Die Aufgabe wird durch die Merkmale des Anspruchs 1 gelöst.

Weitere vorteilhafte Ausgestaltungen der erfindungsgemässen Sonde sind in den Unteransprüchen erwähnt.

Die Sonde kann sich Krümmungsradien von z.B. 50mm oder größer anpassen.

Vorteilhafterweise wird die Flexibilität dadurch erreicht, dass ein durch eine flexible Folie gebildetes Substrat, für die Sonde vorteilhafterweise Polyimid, verwendet wird.

Vorteilhafterweise sind auf der flexiblen Folie bspw. zwei, insbesondere planare Spulen, insbesondere aus Kupfer, als elektrische Bauelemente, aufgebracht.

Die Flexibilität der Sonde bleibt auch durch eine flexible Hinterfütterung der elektrischen Bauelemente erhalten.

Man verwendet für die flexible Hinterfütterung eine Polymerfolie, die mit einem Ferrit gefüllt ist, so dass eine ferromagnetische Signalverstärkung möglich ist.

Ebenso können dünne biegsame Bleche aus Ferrit verwendet werden. Auch eine Vergussmasse mit Ferritteilchen, wobei die Vergussmasse leicht plastisch verformbar ist, kann hier verwendet werden.

Ausführungsbeispiele der Erfindung sind in den Zeichnungen vereinfacht und schematisch dargestellt.

Es zeigen:
Figur 1 eine Anordnung von Erreger und Signalspule,
Figur 2 ein erstes Ausführungsbeispiel einer erfindungsgemäßen Sonde, und
Figur 3 ein weiteres Ausführungsbeispiel einer erfindungsgemäß ausgebildeten Sonde.

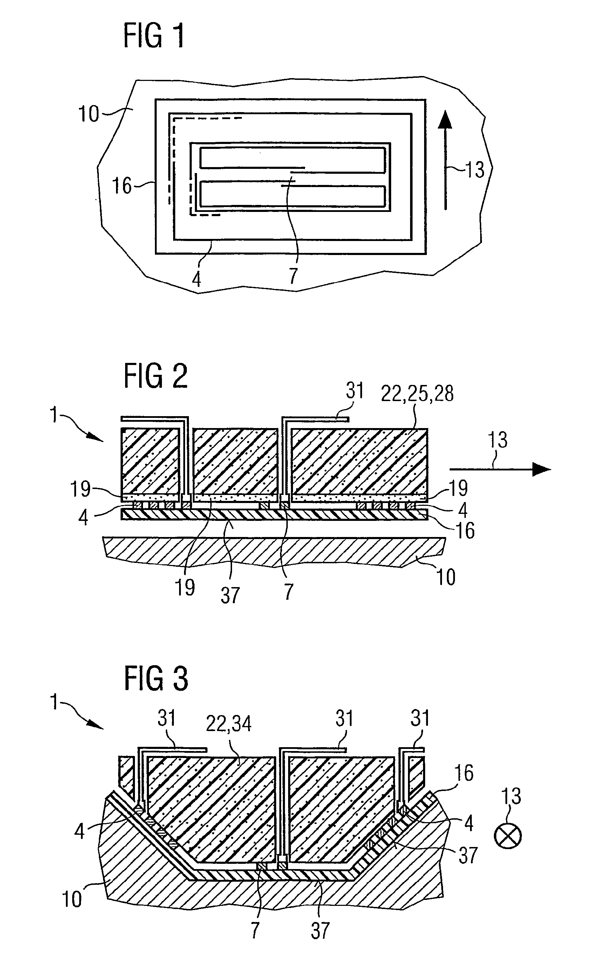

Figur 1 zeigt eine Erregerspule 4 und eine Signalspule 7 als elektrische Bauelemente in ihrer Anordnung in einer Ebene nach dem Stand der Technik.

Die Signalspule 7 ist bspw. von der Erregerspule 4 umgeben. Bezüglich des weiteren beispielhaften Aufbaus von Erregerspule 4, Signalspule 7 und eines Auswertungssystems mit einer Sonde wird auf die DE 197 48 556 A1 verwiesen.

Die Erreger- und Signalspule 4, 7 sind elektrisch voneinander getrennt. Die Signalspule 7 ist in diesem Beispiel als Differenzsonde ausgelegt. Die Ortsauflösung wird bestimmt durch den Abstand der Schwerpunkte der beiden Teilspulen, der sogenannten Baseline.

Die Erregerwicklung 4 umschließt die Teilspulen der Signalspule 7 bspw. symmetrisch, so dass eine Kompensation des Erregerfeldes gewährleistet ist.

Ausführungsbeispiele für Sonden sind:

Eine XXL-Sonde hat eine Baseline von 3,3mm, eine Erregerspule mit 21 Windungen und eine Signalspule mit 8 Windungen. Eine S-Sonde hat eine Baseline mit 2,3mm, eine Erregerspule mit 9 Windungen und eine Signalspule mit 5 Windungen.

Eine Sonde, die unter anderem aus der Erregerspule 4 und Signalspule 7 besteht, wird in einer Scanrichtung 13, gekennzeichnet durch einen Pfeil, über eine Oberfläche eines Prüfkörpers 10 bewegt (durch gestrichelte Umfangslinie angedeutet), wobei die Sonde 1 auf dem Prüfkörper 10 mit einer Auflagefläche 37 (Fig. 2) zur Auflage kommt. Der Prüfkörper 10 enthält beispielsweise Defekte in Form von Rissen, die ein magnetisches Signal der Erregerspule 4 beeinflussen, wodurch die Defekte im Inneren des Prüfkörpers 10 und an dessen Oberfläche festgestellt werden können.

Figur 2 zeigt ein erstes Ausführungsbeispiel für eine Sonde 1 für elektrische Messverfahren gemäß vorliegender Erfindung. Als Substrat 16, das direkt auf dem Prüfkörper aufliegt, wird bspw. eine Folie verwendet, die flexibel ist. Vorzugsweise wird eine Polyimidfolie verwendet.

Auf dem Substrat 16 sind die Erregerspule 4 und die Signalspule 7 bspw. planar angeordnet, d.h. die Spule besteht nur aus einer Leiterbahn, die nur in einer Ebene verläuft. Die Spulen 4, 7 als elektrische Bauelemente können mittels eines Galvanikprozesses oder eines nasschemischen Verfahrens auf die Folie 16 aufgebracht werden.

Auf dem Substrat 16 und auf4 bzw. um die Spulen 4, 7 ist beispielsweise, aber nicht notwendigerweise ein Kleber 19 aufgebracht, der eine Hinterfütterung 22 mit dem Substrat 16 verbindet.

Die Hinterfütterung 22 ist ebenfalls flexibel ausgeführt.

Als Material für die Hinterfütterung 22 wird vorzugsweise ein ferritisches Material (zur ferromagnetischen Signalverstärkung) verwendet mit einer Permeabilität µ bis 100. Durch die Hinterfütterung 22 hindurch führt bspw. zumindest eine elektrische Zuleitung 31 für die Spulen 4, 7 für ein Messsystem wie aus der DE 197 48 556 A1 bekannt.

Als Hinterfütterung 22 kann eine mit Ferritpartikeln befüllte Polymerfolie 25 verwendet werden.

Ebenso ist es möglich, für die Signalverstärkung ein dünnes flexibles Ferritblech zu verwenden.

Die Polyimidfolie 16 hat beispielsweise eine Dicke von 25µm, die Kupferspule eine Dicke von 17 µm, der Kleber erstreckt sich über eine Dicke von ca. 30 µm, und die mit Ferrit gefüllte Polymerfolie über eine Dicke von 200 - 600 µm.

Dieser Schichtstapel bleibt hinreichend flexibel, so dass sich der Schichtstapel verschiedenen Krümmungsradien des Prüfkörpers 10 von z.B. 50mm oder mehr problemlos anpassen lässt.

Figur 3 zeigt ein weiteres Ausführungsbeispiel einer erfindungsgemäß ausgebildeten planaren Sonde 1.

Die Hinterfütterung 22 kann auch durch eine Vergussmaterial 34 gewährleistet sein, in dem Ferritpulver vermischt ist. Der mittlere Durchmesser der Ferritpartikel beträgt z.B. ca. 10µm. Die Vergussmasse ist und bleibt nach einem Aushärtungsprozess leicht plastisch verformbar, so dass eine Flexibilität der Sonde 1 dauerhaft gewährleistet ist.

Eine solche Vergusssonde kann auch verwendet werden um für bestimmte gekrümmte Oberflächen eine starre Sonde 1 herzustellen. Dabei wird eine Vergussmasse 34 verwendet, die sich in dem so verformten Zustand so aushärten lässt, dass sie sich nur noch schwer plastisch verformen lässt und somit dauerhaft an die Kontur bestimmter Prüfkörper 10 angepasst ist. Der Vorteil des Verfahrens liegt dabei darin, dass eine flexible Sonde 1 zunächst einer Oberfläche eines Prüfkörpers 10 ohne großen Aufwand angepasst wird und erst dann die Vergussmasse 34 ausgehärtet wird, so dass kein Luftspalt zwischen der Auflagefläche 37 der Folie 16 und der gekrümmten Oberfläche des Prüfkörpers 10 vorhanden sein kann, der ein Messergebnis verfälscht.

Als elektrisches Messverfahren kann eine Sonde, die bspw. zwei Spulen 4, 7 oder nur eine Spule sowie eine ferromagnetische Signalverstärkung 28 aufweist, zur Wirbelstrommessung genutzt werden, das beispielsweise dazu dient Defekte an metallischen Bauteilen 10 zu detektieren.

## Patentansprüche

1. Sonde (1) für elektrische Messverfahren,
die ein Substrat (16) aufweist,
auf dem zwei elektrische Bauelemente (4, 7) aufgebracht sind,
die zur Auflage auf einem Prüfkörper (10) kommt,
wobei die Sonde (1) mit dem Substrat (16) zur Anpassung an verschiedene Krümmungsradien des Prüfkörpers (10) flexibel ist,
**dadurch gekennzeichnet,**
**dass** die Sonde (1) eine flexible Hinterfütterung (22) aufweist, die die zwei elektrischen Bauelemente (4, 7) zumindest teilweise abdeckt,
**dass** die flexible Hinterfütterung (22) zur ferromagnetischen Signalverstärkung dient und
ausgewählt ist aus:
einem flexiblem Bleche, gebildet aus einem ferritischen Material, oder
einer plastisch verformbaren, mit Ferritteilchen vermischten Vergussmasse (34), oder
einer mit Ferrit gefüllten Polymerfolie.

2. Sonde nach Anspruch 1,
**dadurch gekennzeichnet, dass**
das Substrat (16) eine flexible Folie ist.

3. Sonde nach Anspruch 2,
**dadurch gekennzeichnet, dass**
die Folie (16) aus Polyimid gebildet ist.

4. Sonde nach Anspruch 1,
**dadurch gekennzeichnet, dass**
auf dem Substrat (16) zumindest eine Spule (4, 7) als elektrisches Bauelement, insbesondere eine Kupferspule (4, 7), aufgebracht ist.

5. Sonde nach Anspruch 1,
**dadurch gekennzeichnet, dass**
die Sonde (1) zumindest eine Spule (4, 7) als elektrisches Bauelement aufweist,
die planar auf dem Substrat (16) angeordnet sind.

6. Sonde nach Anspruch 1,
**dadurch gekennzeichnet, dass**
die Sonde (1) eine Sonde (1) für eine Wirbelstrommessung ist.

7. Sonde nach Anspruch 1,
**dadurch gekennzeichnet, dass**
die Sonde (1) Krümmungsradien von bis zu 50mm anpassbar ist.

8. Verwendung einer flexiblen Sonde nach einem der vorherigen Ansprüche zur Herstellung einer unflexiblen Sonde,
wobei die flexible Sonde, die als Hinterfütterung (22) eine flexible aushärtbare Vergussmasse aufweist, einer gekrümmten Oberfläche angepasst wird und
in dieser Form ausgehärtet wird.

## Claims

1. Probe for electrical measurement methods,
which has a substrate (16)
on which two electrical components (4, 7) are fitted
and which comes to rest on a test body (10),
wherein the probe (1) together with the substrate (16) is sufficiently flexible that it can be matched to different radii of curvature of the test body (10),
**characterized in that**
the probe (1) has a flexible rear key (22)
which at least partially covers the two electrical components (4, 7),
**in that** the flexible rear key (22) is used for ferromagnetic signal amplification, and is chosen from:
a flexible metal sheet composed of a ferrite material, or a plastically deformable encapsulation compound (34) mixed with ferrite particles, or by a polymer sheet filled with ferrite.

2. Probe according to claim 1,
**characterized in that**
the substrate (16) is a flexible sheet.

3. Probe according to claim 2,
**characterized in that**
the sheet (16) is formed from polyimide.

4. Probe according to claim 1,
**characterized in that**
at least one coil (4, 7) is fitted to the substrate (16) as an electrical component, in particular a copper coil (4, 7).

5. Probe according to claim 1,
**characterized in that**
the probe (1) has at least one coil (4, 7) as an electrical component, which is arranged in a planar manner on the substrate (16).

6. Probe according to claim 1,
**characterized in that**
the probe (1) is a probe (1) for eddy current measurement.

7. Probe according to claim 1,
**characterized in that**
the probe (1) can be matched to radii of curvature of down to 50 mm.

8. Use of a flexible probe according to one of the preceding claims for production of an inflexible probe, with the flexible probe, which has flexible curable encapsulation compound as the rear key (22), being matched to a curved surface and being cured in this form.

## Revendications

1. Sonde (1) pour des procédés de mesure électriques,
qui comporte un substrat (16),
sur lequel sont déposés deux composants (4, 7) électriques, qui viennent reposer sur une éprouvette (10),
la sonde (1) étant souple avec le substrat (16) pour s'adapter à divers rayons de courbure de l'éprouvette (10),
**caractérisée**
**en ce que** la sonde (1) a une garniture (22) arrière souple qui recouvre au moins en partie les deux composants (4, 7) électriques,
**en ce que** la garniture (22) arrière souple sert à l'amplification ferromagnétique du signal et est choisie parmi :
une tôle souple en un matériau ferritique ou
une composition (34) de scellement déformable plastiquement et mélangée à des particules de ferrite ou
une feuille de polymère chargée de ferrite.

2. Sonde suivant la revendication 1,
**caractérisée en ce que**
le substrat (16) est une feuille souple.

3. Sonde suivant la revendication 2,
**caractérisée en ce que**
la feuille (16) est en polyimide.

4. Sonde suivant la revendication 1,
**caractérisée en ce que**
au moins une bobine (4, 7) est déposée sur le substrat (16)
en tant que composant électrique, notamment une bobine (4, 7) en cuivre.

5. Sonde suivant la revendication 1,
**caractérisée en ce que**
la sonde (1) a au moins une bobine (4, 7) comme composants électriques,
qui sont disposés à plat sur le substrat (16).

6. Sonde suivant la revendication 1,
**caractérisée en ce que**
la sonde (1) est une sonde (1) pour une mesure de courants de Foucault.

7. Sonde suivant la revendication 1,
**caractérisée en ce que**
la sonde (1) peut s'adapter à des rayons de courbure allant jusqu'à 50 mm.

8. Utilisation d'une sonde souple suivant l'une des revendications précédentes pour la fabrication d'une sonde qui n'est pas souple, la sonde souple qui a comme garniture (22) arrière une composition de scellement souple et pouvant durcir, étant adaptée à une surface courbée et durcie en cette forme.
